# EUROPEAN PATENT APPLICATION

(11) **EP 4 636 428 A1**
(43) Date of publication of application: **22.10.2025**
(21) Application number: 24170237.2
(22) Date of filing: 15.04.2024
(51) Int. Cl.: G01R 33/563, G01R 33/48, G01R 33/567

(54) **METHOD FOR OPERATING A MAGNETIC RESONANCE IMAGING DEVICE FOR DIFFUSION IMAGING**

(71) Applicant: Siemens Healthineers AG, 91301 Forchheim (DE); King's College London, London WC2R 2LS (GB)
(72) Inventor: McELROY, Sarah, N16 5UD London (GB); TOMI-TRICOT, Raphael, 92130 Issy-les-Moulineaux (FR); NEJI, Radhouene, N65XP London (GB)
(74) Representative: Siemens Healthineers Patent Attorneys

(57) **Abstract**

The invention relates to a method for operating a magnetic resonance imaging device (16), wherein, for diffusion imaging in an acquisition volume of a patient, a magnetic resonance sequence is used to acquire magnetic resonance diffusion data, wherein the acquisition volume is divided into partitions in a partition direction and the magnetic resonance sequence comprises, in a repetition for each partition:
- a diffusion preparation module (1), comprising at least one tip-down radio frequency pulse (4) and at least one diffusion gradient pulse group following the tip-down pulse (4), and
- a three-dimensional gradient echo readout module (2),
wherein the tip-down radio frequency pulse (4) is slab-selective by applying a slab selection gradient pulse (5) in a phase-encoding direction and the three-dimensional gradient echo module (2) only covers the slab excited by the tip-down radio frequency pulse (4) in the phase-encoding direction.

## Description

The invention concerns a method for operating a magnetic resonance imaging device, wherein, for diffusion imaging in an acquisition volume of a patient, a magnetic resonance sequence is used to acquire magnetic resonance diffusion data in k-space, wherein the magnetic resonance diffusion data is acquired in at least one repetition, the magnetic resonance sequence comprising, in each repetition:
- a diffusion preparation module, comprising at least one tip-down radio frequency pulse, at least one tip-up radio frequency pulse and at least one diffusion gradient pulse group between the tip-down pulse and the tip-up pulse, and
- a readout module.

The invention further concerns a magnetic resonance imaging device, a computer program, and an electronically readable storage medium.

Magnetic resonance imaging (MRI) is a well-known and often-used medical imaging modality. Different aspects of acquisition volumes in a human or animal body may be the subject of the examination by applying different weightings during imaging. A corresponding magnetic resonance sequence is chosen. "Classical" known and used weightings comprise T1 weighting, T2 weighting, T2* weighting and proton density weighting.

Diffusion-weighted imaging (DWI) allows acquiring magnetic resonance diffusion data describing the molecular function and micro-architecture of the body and is an important addition to the above-mentioned weightings. In principle, signal contrast is generated based on the difference of Brownian motion of water molecules by measuring the properties of spins of protons bound in water ("water spins"). For example, diffusion coefficient maps, in particular regarding the apparent diffusion coefficient, can be reconstructed from magnetic resonance diffusion data.

The basic principle of diffusion imaging is to apply symmetric, strong diffusion-sensitizing gradients (often shortly "diffusion gradients") on either side of a 180° refocusing radio frequency pulse after spins have been excited by a tip-down pulse. The phases of stationary spins are not affected by the pair of diffusion gradients. If, however, spins have moved to a different location between the diffusion gradients due to diffusion, they are differently affected and hence fall out of phase, leading to signal loss. After such a diffusion preparation module has been played out, a readout module (image acquisition module) is used to acquire the magnetic resonance diffusion data.

Several applications of diffusion weighted imaging, such as for surgical planning, radiotherapy planning and monitoring of treatment response, require accurate geometric fidelity. Conventional diffusion weighted imaging, which uses a diffusion preparation module with diffusion-sensitizing gradients combined with a two-dimensional spin-echo single-shot echo planar imaging (SS-EPI) readout module, suffers from spatial distortions, especially for high resolution acquisitions and at higher main field strengths, for example 3T or more.

A diffusion-preparation module has been combined with a turbo spin echo (TSE) or balanced steady-state free precession (bSSFP) readout module for distortion-free diffusion imaging, however, such acquisitions suffer from specific absorption rate (SAR) limitations, especially at high main field strength, for example 3T or above. Diffusion preparation modules have also been combined with low SAR T1 gradient-echo readout modules. However, a relatively long readout duration is required, resulting in increased T1 contamination of the acquired magnetic resonance signal. Furthermore, a robust correction for motion-induced magnitude and phase errors has not been provided in the known gradient echo approaches.

It is an object of the present invention to provide a diffusion prepared imaging approach providing high geometric fidelity and data quality, preferably at low specific absorption rate.

This object is achieved by providing an, in particular computer-implemented, method, a magnetic resonance imaging device, a computer program and an electronically readable storage medium according to the independent claims. Advantageous embodiments are described by the dependent claims.

In a method as initially described, according to the invention, the tip-down radio frequency pulse is slab-selective by applying a first slab selection gradient pulse in a phase-encoding direction.

Here, as usual, the partition encoding direction (usually y) is perpendicular to the phase encoding direction (usually z). The readout direction (frequency encoding direction, usually x) is perpendicular to both the phase encoding direction and the partition encoding direction. As principally known, the three-dimensional k-space to be sampled, in particular the sampling positions, and hence the magnetic resonance diffusion data in k-space, may be acquired in one single repetition or may be divided into subsets each acquired in one of multiple repetitions (shots). In each repetition, which comprises a diffusion preparation module and a readout module, magnetic resonance diffusion data are acquired for the whole k-space to be sampled or one subset. For example, 10 to 100 subsets may be used, also defining the number of required repetitions. It is noted, that, as usual, multiple magnetic resonance diffusion data sets may be acquired for different b values. A b=0 data set may be acquired by leaving out the diffusion gradient pulse group.

Preferably, at the beginning of the diffusion preparation module, a saturation pulse, in particular a fat saturation radio frequency pulse, is output to saturate the magnetization of spins which are not of interest, in particular non-water spins (that is, spins of protons not bound in water). Of course, other fat saturation and fat suppression techniques may also be employed.

The diffusion gradient pulse group comprises at least one diffusion gradient pulse and at least one refocusing, in particular 180°, radio frequency pulse. As further discussed below, the concrete structure of the diffusion gradient pulse group may preferably be chosen to supress artifacts, in particular by supressing eddy currents, reducing spatial distortion and the like, to allow best image quality regarding these aspects.

The tip-down radio frequency pulse preferably has a flip angle of 90° (90° tip-down pulse). It is applied slab selectively, that is, it is output simultaneously with a slab selection gradient pulse in the phase encoding direction. Hence, excitation is restricted spatially to the spins of interest, in particular spins of protons bound in water ("water spins") if fat suppression or saturation has been applied. The field of view is hence reduced in the phase-encoding direction, such that the approach described here may be called a reduced field of view (rFOV) approach. In preferred embodiments, where the readout module is three-dimensional, the readout module may also be slab-selective by applying a second slab selection gradient pulse in a partition encoding direction, which is orthogonal to the phase-encoding direction. Hence, also in the phase encoding direction, the field of view can be reduced. In such a case, of course, the readout module may still comprise phase encoding gradients and respective rewinder gradients in the partition encoding direction in addition to the second slab selection gradient.

The diffusion preparation module also, as known, comprises at least one tip-up radio frequency pulse succeeding the diffusion gradient pulse group. The tip-up radio frequency pulse may correspond to the tip-down radio frequency pulse, in particular at least regarding the flip angle. A slab selectivity for the tip-up radio frequency pulse is not required. Hence, the tip-up radio frequency pulse is preferably non-selective. The tip-up radio frequency pulse may preferably be followed by a spoiler gradient pulse which dephases any remaining transverse magnetisation from spins outside the reduced field of view.

Reducing the field of view in the phase encoding direction allows to use shorter readout modules, since the number of phase encoding steps in the readout module can be reduced to fit the reduced field of view. For example, half as many or even less than half as many phase encoding steps as used without slab selectivity of the tip-down radio frequency pulse may be required, This allows to reduce the duration of the readout module, thereby increasing relative diffusion weighting and reducing T1 contamination. This is especially advantageous for three-dimensional readout modules, but can also be applied to two-dimensional readout modules. In preferred embodiments, the readout module may be a gradient echo (GRE) readout module. In this manner, the advantages of the gradient echo readout, in particular its low SAR, may be utilized.

In summary, the diffusion preparation module is combined with a two-dimensional or, preferably, three-dimensional readout module, wherein the tip-down radio frequency pulse of the diffusion preparation module is applied simultaneously with a slab-selective gradient (of the slab selection gradient pulse) in the phase-encoding direction, thereby restricting excitation to a reduced field of view, namely the slab, in this direction, and hence allowing for a reduced readout time which results in lower T1 contamination and higher relative diffusion weighting. The magnetic resonance sequence described here can be understood as an, in particular three-dimensional, reduced field of view diffusion-prepared magnetic resonance imaging sequence.

In preferred embodiments, the readout module uses a centric encoding scheme in the phase-encoding direction, in particular starting at the central k-space line in the phase-encoding direction. Hence, the most central k-space line, where most of the signal is found, is acquired first, such that its magnetic resonance diffusion data has the most diffusion weighting and is least affected by possible T1 contamination. This further reduces this effect and improves diffusion data quality. In particular, cartesian sampling may be used. For example, for each repetition, an excitation radio frequency pulse is played out, in particular during respective second slab-selection gradient pulses in the partition encoding direction. The excitation radio frequency pulse may be followed by pairs of phase encoding gradient pulses and phase rewinder gradient pulses both for the phase encoding direction and the partition encoding direction. A readout gradient pulses is output in a readout direction perpendicular to both the phase encoding direction and the partition encoding direction between the respective phase encoders and rewinders.

As already discussed, a tip-up radio frequency pulse is used following the diffusion gradient group in the diffusion preparation module. Preferably, the tip-up radio frequency pulse is preceded by a magnetization stabilizer gradient pulse, in particular in the partition encoding direction, of the diffusion preparation module and the readout module comprises a stabilizer rewinding gradient pulse in the stabilization direction output after each excitation radio frequency pulse of the readout module. The stabilizer rewinding gradient pulse has opposing polarity regarding the magnetization stabilizer gradient pulse. Magnitude stabilization techniques are known in the art for other applications and solve the problem of unknown phases of the transverse magnetization before applying a radio frequency pulse, in this case the tip-up radio frequency pulse. Depending on the phase position, the radio frequency pulse may affect all from no magnetization to the whole magnetization. By dephasing the spins using the magnetization stabilizer gradient, at least half of the spins are reliably affected, leading to magnitude stabilization. However, to revert phase-induced magnitude inconsistencies, that would normally occur after the diffusion preparation module, back into phase inconsistencies, the stabilizer rewinding gradient pulses are applied during the readout module for each excitation radio frequency pulse. However, these stabilizer rewinding gradient pulses also act as a spoiler gradient for the magnetization in the outer volume, that is, outside the slab, supressing unwanted signals. In concrete embodiments, the magnitude stabilizer gradient pulse may be output following the diffusion gradient pulse group.

In principle, the magnitude stabilizer gradient pulse can be output in any direction. Preferably, the magnitude stabilizer gradient pulse is output in the partition encoding direction and the stabilizer rewinding gradient pulse is included in a phase encoding gradient pulse in the partition encoding direction associated with the excitation radio frequency pulse. For example, the partition stabilizer rewinding gradient can be incorporated into the phase encoding gradient as an additional moment, corresponding to the moment of the magnitude stabilizer gradient pulse. In this manner, no additional gradient pulse is required.

As already noted, preferably, a spoiler gradient pulse is applied, for example in the partition encoding direction, between the tip-up radio frequency pulse and the gradient echo readout module. Such a spoiler gradient pulse acts to dephase any remaining transverse magnetization, including in the outer volume and/or of non-water spins, for example those of protons bound in fat.

In preferred embodiments, each readout module comprises, at its end, a phase navigator submodule for measuring phase information associated with the respective repetition, wherein the phase information is used to correct the acquired magnetic resonance diffusion data regarding phase offsets between repetitions. Here, if a magnetization stabilizer gradient pulse is used, the stabilizer rewinding gradient pulse is preferably also applied in the phase navigator submodule. Hence, a phase navigator (or phase correction navigator) can be used to keep track of phase and correct any inter-repetition (inter-shot) phase offsets. Preferably, the phase information measured is two-dimensional, in particular comprising the k-space center. A two-dimensional phase navigator can quickly be measured and, in particular if placed in the k-space center, yields all required information in evaluable form. The two-dimensional phase navigator may preferably be linearly encoded. The phase information may be repetition-wise applied to correct phase offsets between repetitions. Preferably, the phase information may be determined for each receiving coil element by applying an inverse Fourier transform to the navigator data set acquired in a respective repetition. A Hamming filter may then be applied to the transformed navigator data set to determine the phase information. To correct, an inverse Fourier transform is applied to the magnetic resonance diffusion data subset of the respective repetition and receiving coil element. The phase information is applied as a correction to the transformed subset. To transform the corrected data back into k-space, a Fourier transform is applied to the corrected subset. All corrected magnetic resonance diffusion data subsets for each receiving coil element and repetition then form the corrected magnetic resonance diffusion data set, from which, for example, a diffusion weighted image, a diffusion coefficient map and the like can be reconstructed.

Preferably, the slab dimension in the phase encoding direction is chosen to cover a whole region of interest of the acquisition volume. Hence, only one slab has to be acquired. It is, however, also conceivable to define two or more slabs covering the region of interest and acquire their respective magnetic resonance diffusion data in successive imaging processes, each using the magnetic resonance sequence as described above with accordingly chosen slab selection gradient pulses. If a reduced field of view is also used in the partition encoding direction, the slab dimension in the partition encoding direction may also be chosen to cover the whole region of interest of the acquisition volume.

Regarding the diffusion gradient group, many known concrete configurations may be employed. Diffusion gradient groups have been optimized in the art, in particular regarding eddy currents and reduction of spatial distortion artifacts. For example, bipolar diffusion gradient pulses may be used and twice-refocused techniques may be applied. In preferred embodiments of the invention, a bipolar twice-refocused diffusion preparation may be used, significantly reducing spatial distortion artifacts and hence further improving spatial accuracy. In these embodiments, the diffusion gradient group comprises a pair of bipolar diffusion gradient pulses, each surrounding a 180° adiabatic refocusing radio frequency pulse. The refocusing radio frequency pulse is output between the two sub-pulses of opposite polarity of the bipolar diffusion gradient pulse, in particular at zero gradient strength of the bipolar diffusion gradient pulse. However, as mentioned, other diffusion preparation techniques may also be employed.

The combination of slab-selectivity in the phase encoding direction, allowing shorter gradient echo readout modules, with magnitude stabilization, a phase navigator and in particular also a diffusion preparation scheme reducing geometric distortion synergize to allow a diffusion magnetic resonance measurement with especially high overall diffusion data quality, and, in particular, high geometric fidelity and accuracy. If a gradient echo readout is used, a low SAR may also be achieved.

The invention also concerns a magnetic resonance imaging device, comprising a control device having an acquisition unit, wherein the acquisition unit is configured, for diffusion imaging in an acquisition volume of a patient, to use a magnetic resonance sequence to acquire magnetic resonance diffusion data in k-space in at least one repetition, the magnetic resonance sequence comprising, in each repetition:
- a diffusion preparation module, comprising at least one tip-down radio frequency pulse, at least one tip-up radio frequency pulse and at least one diffusion gradient pulse group between the tip-down radio frequency pulse and the tip-up radio frequency pulse, and
- a readout module,
wherein the acquisition unit is further configured to apply the tip-down radio frequency pulse slab-selectively by using a first slab selection gradient pulse in a phase-encoding direction.

All remarks and features regarding the method according to the invention can analogously be applied to the magnetic resonance imaging device of the invention and vice versa, such that the same advantages may be achieved.

The control device may comprise at least one processor and at least one storage means. Functional units may be implemented by hardware and/or software, comprising an acquisition unit to control acquisition equipment of the magnetic resonance imaging device to acquire magnetic resonance data, in particular magnetic resonance diffusion data using the magnetic resonance sequence as described above. In particular, the magnetic resonance imaging device may comprise a main magnet unit comprising a main magnet, which generates a main magnetic field in a bore of the main magnet unit. The acquisition equipment may comprise at least one gradient coil assembly to output gradient pulses and at least one radio frequency coil assembly to output radio frequency pulses and/or receive magnetic resonance signals. At least one radio frequency coil assembly may comprise multiple coil elements, which may be used independently for transmitting and/or receiving.

A computer program according to the invention comprises program means such that, when the computer program is executed on a control device of a magnetic resonance imaging device, the control device is caused to perform a method according to the invention. The computer program may be stored on an electronically readable storage medium according to the invention, which hence comprises control information stored thereon, which comprises a computer program according to the invention and is configured such that, when the storage medium is used in a control device of a magnetic resonance imaging device, the control device is configured to perform a method according to the invention. The electronically readable storage medium may be a non-transitory medium, for example a CD ROM.

Other objects and features of the present invention will become apparent from the following detailed description considered in conjunction with the accompanying drawings. The drawings, however, are only principle sketches designed solely for the purpose of illustration and do not limit the invention. The drawings show:
- Fig. 1: a sequence diagram of a magnetic resonance sequence used in an embodiment of a method according to the invention,
- Fig. 2: a flowchart of a method according to the invention, and
- Fig. 3: a magnetic resonance imaging device according to the invention.

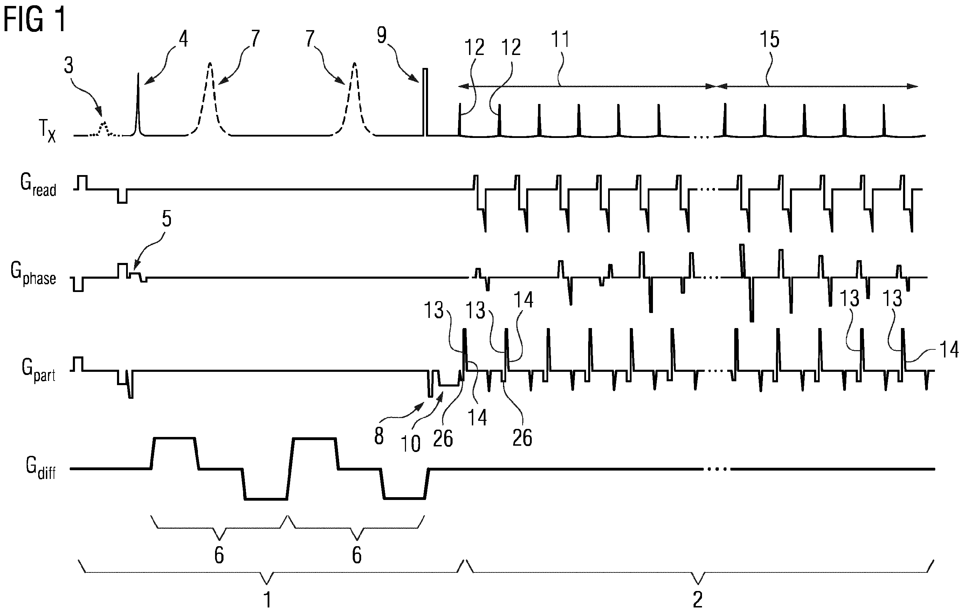

Fig. 1 shows a sequence diagram of one repetition of a magnetic resonance sequence to be used in a method according to the invention. The uppermost graph shows radiofrequency activity (Tx), the next gradient activity in a readout direction (G_{read}), the middle graph gradient activity in a phase encoding direction (Pₚₕₐₛₑ), the next-to-lowest graph gradient activity in a partition encoding direction (Gₚₐᵣₜ) and the final graph diffusion gradient activity (G_{diff}). In the following, not all radio frequency pulses and gradient pulses will be discussed in detail, but the focus will be on the relevant design regarding optimized diffusion data quality, in particular regarding geometric fidelity and accuracy, while minimizing SAR and T1 contamination and maximizing diffusion weighting. In the current example, the used magnetic resonance imaging device provides a main magnetic field of 3T or more. The magnetic resonance sequence uses a twice-refocused bipolar diffusion preparation scheme combined with a gradient echo readout, followed by a two-dimensional phase correction navigator.

In each repetition, as shown in Fig. 1, a subset of the k-space to be acquired is three-dimensionally measured using respective encoding, in particular phase encoding steps. For example, 10 to 100 encodings and hence repetitions can be used. The sequence described here can, of course, also be applied in the case of a single repetition. Each repetition, as shown in Fig. 1, comprises a diffusion preparation module 1 and a readout module 2. At the beginning of the diffusion preparation module, a fat saturation radio frequency pulse 3 (accompanied by respective gradient pulses) is output to saturate fat spins, such that the diffusion of water can be reliably measured by receiving signals from water spins.

Immediately after the fat saturation radio frequency pulse 3, a 90° tip-down radio frequency pulse 4 is output simultaneously with a slab selection gradient pulse 5, such that the 90° tip-down radio frequency pulse 4 only acts on a certain slab, which, in this case, covers the whole region of interest, that is, the relevant acquisition volume, in the phase encoding direction. Hence, by slab selectivity, a reduced field of view is excited. The diffusion preparation group following the excitation comprises a pair of bipolar diffusion gradient pulses 6, each surrounding a 180° adiabatic refocusing radio frequency pulse 7.

A magnitude stabilizer gradient pulse 8 is applied in the partition encoding direction directly before a non-selective tip-up radio frequency pulse 9 to fully dephase spins across the selected slab. Following the tip-up radio frequency pulse 9, a spoiler gradient pulse 10 is applied to dephase any remaining transverse magnetization, including in the outer volume (outside the selected slab) and/or fat spins.

The readout module 2 comprises gradient echo readout submodules in a first time interval 11 for each k-space phase encoding line to be acquired, wherein centric encoding is used regarding the order of the phase encoding lines. A magnitude stabilizer rewinder gradient pulse is played out after each excitation radio frequency pulse 12, thereby reverting phase-induced magnitude inconsistencies back into phase inconsistencies. In this embodiment, the stabilizer rewinder gradient pulse is incorporated as additional moment 13 into phase encoding gradient pulses 14. Also in this embodiment, with each excitation radio frequency pulse 12, second slab selection gradient pulses 26 are output, which provide slab-selectivity also in the partition encoding direction. Due to the centric encoding, most of the signal is acquired with maximized diffusion weighting and almost no T1 contamination. The gradient echo readout is shortened compared to a non-slab-selective excitation, further preventing T1 contamination, yet still covering the required range in phase-encoding direction.

After the first time interval 11, in a second time interval 15 of the readout module 2, a two-dimensional phase correction navigator is acquired in a phase navigator submodule. Here, of course, the stabilizer rewinder gradient pulses are still applied. Phase information determined from phase navigator data sets for partitions and each receiving coil element is used to correct the respective magnetic resonance diffusion data subsets of the respective partition and receiving coil element. An inverse Fourier transform is applied to each phase navigator data set, followed by a Hamming filter to determine phase information. An inverse Fourier transform is then applied to each magnetic resonance diffusion data subset, followed by a phase correction using the phase information for each receiving coil element. A Fourier transform is then applied to the corrected magnetic resonance diffusion data subset. In this manner, inter-repetition phase inconsistencies are corrected.

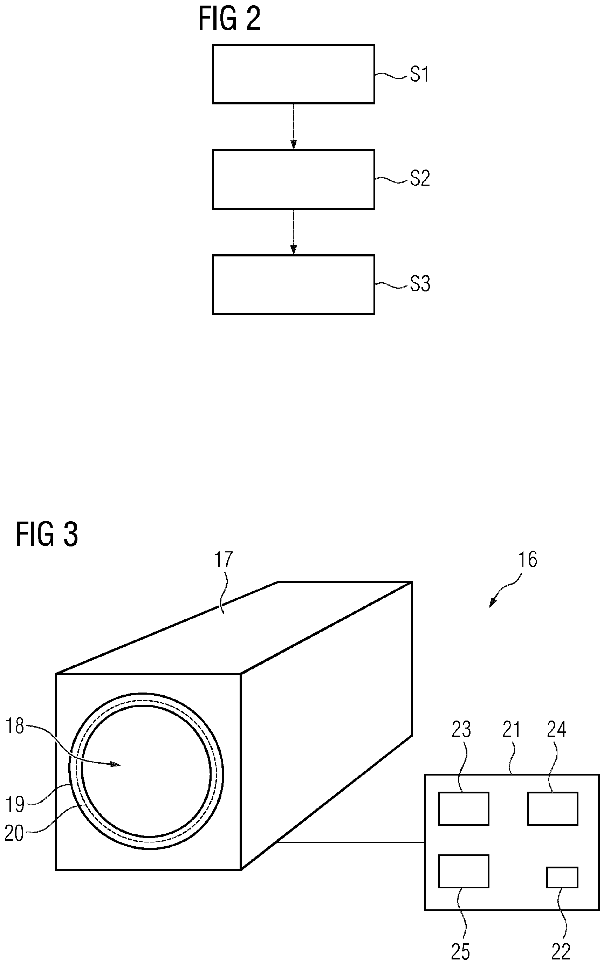

Fig. 2 shows a flowchart of a method according to the invention. In a step S1, magnetic resonance diffusion data and phase navigator data are acquired using the magnetic resonance sequence of Fig. 1. In a step S2, correction for phase inconsistencies is performed using the phase navigator data. Hence, in a step S3, based on the corrected magnetic resonance diffusion data, a diffusion-weighted image, a diffusion coefficient map and the like can be reconstructed.

Fig. 3 schematically shows a magnetic resonance imaging device 16 according to the invention. The magnetic resonance imaging device 16 comprises a main magnet unit 17 housing a main field magnet (not shown), in this case generating a main magnetic field of 3T or more. The main magnet unit comprises a bore 18, into which a patient can be introduced using a patient table (not shown). Surrounding the bore, a gradient coil assembly 19 and a radio frequency coil assembly 20 are indicated. Local coils may, of course, also be used.

The operation of the magnetic resonance imaging device 16 is controlled by a control device 21, whose functional structure is indicated. The control device 21 comprises a storage means 22 for storing data, for example magnetic resonance diffusion data and phase navigator data. An acquisition unit 23 controls the acquisition equipment comprising coil assemblies 19, 20 to output pulses according to magnetic resonance sequences, in particular also the one shown in Fig. 1 for diffusion imaging according to step S1. In a correction unit 24, the correction according to step S2 may be applied. The control device 21 further comprises a reconstruction unit 25 for reconstructing magnetic resonance images and maps, in particular according to step S3.

Independent of the grammatical term usage, individuals with male, female or other gender identities are included within the term.

## Claims

1. Method for operating a magnetic resonance imaging device (16), wherein, for diffusion imaging in an acquisition volume of a patient, a magnetic resonance sequence is used to acquire magnetic resonance diffusion data in k-space, wherein the magnetic resonance diffusion data is acquired in at least one repetition, the magnetic resonance sequence comprising, for each repetition:
- a diffusion preparation module (1), comprising at least one tip-down radio frequency pulse (4), at least one tip-up radio frequency pulse (9) and at least one diffusion gradient pulse group between the tip-down radio frequency pulse (4) and the tip-up radio frequency pulse (9), and
- a readout module (2),
wherein the tip-down radio frequency pulse (4) is slab-selective by applying a first slab selection gradient pulse (5) in a phase-encoding direction.

2. Method according to claim 1, **characterized in that** the readout module (2) uses a centric encoding scheme starting at the k-space center in the phase encoding direction.

3. Method according to claim 1 or 2, **characterized in that** the tip-up radio frequency pulse (9) is preceded by a magnetization stabilizer gradient pulse (8) and the readout module (2) comprises a stabilizer rewinding gradient pulse in the stabilization direction output after each excitation radio frequency pulse (12) of the readout module (2).

4. Method according to claim 3, **characterized in that** the magnetization stabilizer gradient pulse (8) is following the diffusion gradient pulse group.

5. Method according to claim 3 or 4, **characterized in that** the magnetization stabilizer gradient pulse (8) is output in the partition encoding direction and the stabilizer rewinding gradient pulse is included in a phase encoding gradient pulse (14) in the partition encoding direction associated with the excitation radio frequency pulse (12).

6. Method according to one of the preceding claims, **characterized in that** a spoiler gradient pulse (10) is applied between the tip-up radio frequency pulse (9) and the readout module (2).

7. Method according to one of the preceding claims, **characterized in that** each readout module (2) comprises, at its end, a phase navigator submodule for measuring phase information associated with the respective repetition, wherein the phase information is used to correct the acquired magnetic resonance diffusion data regarding phase offsets between repetitions.

8. Method according to claim 7, **characterized in that**, if a magnetization stabilizer gradient pulse (8) is used, the stabilizer rewinding gradient pulse is also applied in the phase navigator submodule.

9. Method according to claim 7 or 8, **characterized in that** the measured phase information is two-dimensional, in particular comprising the k-space center.

10. Method according to one of the preceding claims, **characterized in that** the slab dimension in the phase encoding direction is chosen to cover a whole region of interest of the acquisition volume.

11. Method according to one of the preceding claims, **characterized in that** the readout module (2) is three-dimensional and/or a gradient echo readout module.

12. Magnetic resonance imaging device (16), comprising a control device (21) having an acquisition unit (23), wherein the acquisition unit (23) is configured, for diffusion imaging in an acquisition volume of a patient, to use a magnetic resonance sequence to acquire magnetic resonance diffusion data in k-space in at least one repetition, the magnetic resonance sequence comprising, in each repetition:
- a diffusion preparation module (1), comprising at least one tip-down radio frequency pulse (4), at least one tip-up radio frequency pulse (9) and at least one diffusion gradient pulse group between the tip-down radio frequency pulse (4) and the tip-up radio frequency pulse (9), and
- a readout module (2),
wherein the acquisition unit is further configured to apply the tip-down radio frequency pulse (4) slab-selectively by using a first slab selection gradient pulse (5) in a phase-encoding direction.

13. Computer program, which, when it is executed in a control device (21) of a magnetic resonance imaging device (16), causes the control device (21) to perform the steps of a method according to one of the claims 1 to 11.

14. Electronically readable storage medium, on which a computer program according to claim 13 is stored.
